(19) Europäisches Patentamt
European Patent Office
Office européen des brevets

(11) **EP 4 701 015 A1**

(12) **EUROPÄISCHE PATENTANMELDUNG**

(43) Veröffentlichungstag:
**25.02.2026 Patentblatt 2026/09**

(21) Anmeldenummer: **24195166.4**

(22) Anmeldetag: **19.08.2024**

(51) Internationale Patentklassifikation (IPC):
**H02H 3/04** *(2006.01)* **G01R 31/62** *(2020.01)*
**H02H 3/05** *(2006.01)*

(52) Gemeinsame Patentklassifikation (CPC):
**H02H 3/044; G01R 31/52; G01R 31/62;** H02H 3/05

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft
80333 München (DE)**

(72) Erfinder:
• **Kerger, Torsten
14621 Schönwalde-Glien (DE)**
• **Matussek, Robert
10365 Berlin (DE)**
• **Mieske, Frank
13053 Berlin (DE)**

(74) Vertreter: **Siemens Patent Attorneys
Postfach 22 16 34
80506 München (DE)**

(54) **FEHLERDETEKTION FÜR EINEN STROMWANDLER**

(57) Beschrieben ist ein Verfahren eines Detektierens eines Fehlers, insbesondere Unterbrechung, in einem Sekundärstromkreis (6) eines Stromwandlers (3), dessen Primärleiter (4) durch einen Teil eines Hochspannungsleiters (2) gebildet ist, wobei das Verfahren aufweist: Schließen auf einen Fehler im Sekundärstromkreis (6), falls ein Betrag des Strommittelwertes (20) bezogen auf einen Zeitpunkt, der in einem Auswahlzeitintervall ($\Delta tA$) liegt, kleiner ist als eine Stromwertschwelle (21), wobei das Auswahlzeitintervall ($\Delta tA$) basierend auf einer Stromwertänderungsgröße (22) und einer Stromwertänderungsschwelle (23) bestimmt ist, wobei die Stromwertänderungsgröße (22) basierend auf mindestens zwei, verschiedenen Zeitpunkten zugeordneten, Stromwerten (13) eines in dem Sekundärstromkreis (6) fließenden elektrischen Stromes ($I\_P$) gebildet ist.

FIG 1

EP 4 701 015 A1

**Beschreibung**

GEBIET DER ERFINDUNG

Die vorliegende Erfindung betrifft ein Verfahren und eine entsprechende Vorrichtung zur Fehlerdetektion in einem Sekundärstromkreis eines Stromwandlers, dessen Primärleiter durch einen Teil eines Hochspannungsleiters gebildet ist. Ferner betrifft die vorliegende Erfindung ein Verfahren und ein entsprechendes System eines Überwachens und/oder Durchführens einer Schutzfunktion eines Hochspannungsleiters.

STAND DER TECHNIK

In einem Hochspannungsnetz bzw. in einem Hochspannungskabel können herkömmlicherweise Stromwandler zur Strommessung vorgesehen sein. Die Stromwandler können Messsignale an nachgeordnete Systeme weiterleiten, die basierend auf den Messwerten des Stromwandlers Schutzfunktionen für ein Schutzobjekt, zum Beispiel eine Hochspannungsleitung durchführen können. Bei Fehlern im Sekundärkreis der Stromwandler können jedoch falsche elektrische Zustände in dem Schutzobjekt vorgetäuscht werden und es können nachfolgend fälschlicherweise Schutzfunktionen durchgeführt werden, die zum Beispiel zu einer Unterbrechung einer Energieversorgung für Verbraucher führen können.

Es ist beobachtet worden, dass Fehlererkennung für einen Stromwandler herkömmlich nicht zufriedenstellend durchgeführt werden kann bzw. nicht unter allen Bedingungen und Umständen zuverlässig durchgeführt werden kann.

Somit ist es eine Aufgabe der vorliegenden Erfindung, ein Verfahren bzw. eine entsprechende Vorrichtung zum Detektieren eines Fehlers im Sekundärkreis eines Stromwandlers, insbesondere einer Unterbrechung, zu schaffen, wobei zuverlässig ein Fehler detektiert werden kann, um insbesondere ein fehlerhaftes Durchführen oder Ansprechen von Schutzfunktionen zu vermeiden. Ferner ist es eine Aufgabe der vorliegenden Erfindung, ein Verfahren bzw. ein System zum Überwachen und/oder Durchführen einer Schutzfunktion des Hochspannungsleiters bereitzustellen, welches auch etwaige Fehler in einer Messeinrichtung zu detektieren in der Lage ist, um somit die Überwachung zu verbessern und auch das Durchführen einer Schutzfunktion nur bei zuverlässig erkanntem Fehler in dem Hochspannungsleiter durchzuführen.

ZUSAMMENFASSUNG DER ERFINDUNG

Die Aufgabe wird durch den Gegenstand der unabhängigen Ansprüche gelöst, welche auf ein Verfahren bzw. eine Vorrichtung zum Detektieren eines Fehlers in einem Sekundärstromkreis eines Stromwandlers gerichtet sind. Ferner wird die Aufgabe durch die Merkmale des Verfahrensanspruchs bzw. Systemanspruchs zum Überwachen und/oder Durchführen einer Schutzfunktion eines Hochspannungsleiters gelöst. Die abhängigen Ansprüche spezifizieren besondere Ausführungsformen der vorliegenden Erfindung.

Gemäß einer Ausführungsform der vorliegenden Erfindung ist ein Verfahren eines Detektierens eines Fehlers, insbesondere Unterbrechung, in einem Sekundärstromkreis eines Stromwandlers, dessen Primärleiter durch einen Teil eines Hochspannungsleiters gebildet ist, bereitgestellt, wobei das Verfahren aufweist: Schließen auf einen Fehler im Sekundärstromkreis, falls der Betrag eines Strommittelwertes bezogen auf einen Zeitpunkt, der in einem Auswahlzeitintervall liegt, kleiner ist als eine Stromwertschwelle, wobei das Auswahlzeitintervall basierend auf einer Stromwertänderungsgröße und einer Stromwertänderungsschwelle bestimmt ist, wobei die Stromwertänderungsgröße basierend auf mindestens zwei, verschiedenen Zeitpunkten zugeordneten, Stromwerten eines in dem Sekundärstromkreis fließenden elektrischen Stromes gebildet ist.

Das Verfahren kann in Software und/oder Hardware implementiert werden. Das Verfahren kann zum Beispiel als Teil oder Modul eines Schutzgerätes implementiert werden, welches zum Beispiel mit dem Stromwandler verbunden ist, um Messdaten des Stromwandlers zu empfangen. Der Stromwandler ist ein Messwandler, der als Maß für einen schwer messbar großen elektrischen Strom ein leicht verarbeitbares elektrisches Signal, zum Beispiel Spannungssignal, erzeugen kann. Der Stromwandler kann als ein Transformator ausgelegt sein oder einen Transformator umfassen. Der Stromwandler kann in dem Sekundärstromkreis einen Sekundärstrom als Ausgangssignal in der Größenordnung von Milliampere bis einigen (z.B. 1 bis 500) Ampere abgeben, welches zum Beispiel proportional zum zu messenden Primärstrom in dem Hochspannungsleiter sein kann. Der Sekundärstromkreis kann eine Sekundärspule mit mehreren Windungen umfassen. Je nach Hochspannungswerten in dem Hochspannungsleiter kann der Stromwandler auf die Erfordernisse angepasst werden.

Der Stromwandler kann für Schutzzwecke vorgesehen sein, insbesondere zur Übertragung eines herabgesetzten Stromes an eine oder mehrere Schutzgeräte, zum Beispiel Schutzrelais, Steuergeräte oder Regelgeräte. Der Stromwandler kann zum Beispiel als ein induktiver Stromwandler ausgebildet sein, wobei er nur eine oder wenige Primärwindungen hat, die vom zu messenden Primärstrom durchflossen werden, sowie eine größere Anzahl von Sekundärwindungen in dem Sekundärstromkreis. Die Primärwicklung kann aus einer durch einen (ferromagnetischen) Ringkern des Wandlers geführten Stromschiene bestehen, was einer einzigen Primärwindung entspricht. Der Sekundärstrom ist gegenüber dem zu messenden Primärstrom verringert und zwar umgekehrt proportional zum Verhältnis der Primär- und Sekundärwindungszahl.

Der Sekundärstromkreis kann ein Strommessgerät umfassen. Der Stromwandler kann sekundärseitig über ein Kabel, zum Beispiel an eine Sammeleinrichtung und/oder Messgerät, und/oder Zähler und/oder Schutzeinrichtung und/oder Steuergerät angeschlossen sein, zum Beispiel um ein Schutzobjekt, zum Beispiel die Hochspannungsleitung, zu schützen.

Konventionell können bei Unterbrechungen im Sekundärstromkreis des Stromwandlers durch Kabelbruch zum Beispiel bei einem Differentialschutz Differenzströme vorgetäuscht, wie sie auch von Kurzschlüssen im Schutzobjekt hervorgerufen werden können. Dadurch kann es herkömmlicherweise zu einer unerwünschten Überfunktion des Differentialschutzes und damit einhergehend zum fehlerhaften Auslösen eines Leistungsschalters kommen, womit die Stabilität der Energieversorgung gefährdet wird. Herkömmliche Verfahren zur Kabel- und Drahtbrucherkennung erkennen reale Kabelbrüche nicht zuverlässig (Unterfunktion), andererseits spricht die Erkennung bei kleinen Strömen unerwünscht an (Überfunktion).

Ausführungsformen der vorliegenden Erfindung stellen ein zuverlässiges Detektieren eines Fehlers in einem Sekundärstromkreis des Stromwandlers, insbesondere einer Unterbrechung, bereit. Das Verfahren kann umfassen, mehrere zeitlich aufeinanderfolgende Stromwerte eines in dem Sekundärstromkreis fließenden Stromes (welcher in dem Hochspannungsleiter fließt) zu messen. Die Messung kann zeitlich wiederholend mit einer bestimmten festgelegten Abtastfrequenz erfolgen. Der Strommittelwert kann als ein Mittelwert und/oder RMS-Wert und/oder Effektivwert des in dem Sekundärstromkreis fließenden Stromes gebildet werden. Zur Berechnung des Strommittelwertes werden mindestens zwei Stromwerte, die mindestens zwei verschiedenen Zeitpunkten zugeordnet sind, verwendet. Es können zum Beispiel zwischen 2 bis 10 Stromwerte zur Berechnung des Strommittelwerts herangezogen werden, andere Anzahlen sind möglich.

Die Stromwertschwelle kann derart gewählt werden, dass sie unterhalb von (bei fehlerlosem Hochspannungsleiter) erwarteten Strommittelwerten liegt. Der Betrag des Strommittelwerts kann mit der Stromwertschwelle verglichen werden.

Das Auswahlzeitintervall kann in Abhängigkeit der Stromwertänderungsgröße und der Stromwertänderungsschwelle bestimmt sein, kann oder muss somit nicht eine fest vorbestimmte Zeitdauer umfassen, sondern kann abhängig sein von der elektrischen Stromcharakteristik der in dem Sekundärstromkreis ermittelten Stromwerte. Die Stromwertänderungsgröße kann eine zeitliche Änderung von zumindest zwei Stromwerten repräsentieren und kann somit zum Beispiel zumindest auf einer Differenz zweier Stromwerte ermittelt werden, die verschiedenen Zeitpunkten zugeordnet sind.

Die Stromwertänderungsschwelle kann, muss jedoch nicht, eine fest voreingestellte Größe haben. Insbesondere kann die Stromwertveränderungsschwelle auch dynamisch in Abhängigkeit der Größe des Sekundärstroms berechnet werden.

Wenn das Auswahlzeitintervall basierend auf oder in Abhängigkeit von der Stromwertänderungsgröße und der Stromwertänderungsschwelle bestimmt ist, kann eine Zuverlässigkeit des Detektierens des Fehlers in dem Sekundärstromkreis verbessert werden. Insbesondere kann das Auswahlzeitintervall eine verzögerte Auswertung bzw. Prüfung ermöglichen, ob der Strommittelwert kleiner ist als die Stromwertschwelle.

Gemäß einer Ausführungsform der vorliegenden Erfindung liegt das Auswahlzeitintervall ab oder nach einem ersten Zeitpunkt, bei dem ein Stromsprung detektiert wurde, insbesondere bei dem sich mindestens ein Stromwert von einem erwarteten Stromwert, insbesondere eines sinusförmigen Verlaufes, um mehr als eine vorbestimmte Stromwertabweichung unterscheidet.

Wenn zusätzlich (insbesondere vorher) der Stromsprung detektiert wurde, kann weiter eine Zuverlässigkeit der Detektion des Fehlers in dem Sekundärstromkreis verbessert werden. Erwartete Stromwerte können zum Beispiel einer Sinus- bzw. verschobenen Sinuskurve entsprechen. Es können zum Beispiel Differenzen der beobachteten Stromwerte von den erwarteten Stromwerten gebildet werden und es kann zum Beispiel bestimmt werden, ob sich die bestimmten Differenzen zeitlich vergrößern oder verkleinern. Wenn sich die Differenzen zum Beispiel zeitlich vergrößern und oberhalb einer Abweichungsschwelle liegen, kann auf einen Stromsprung geschlossen werden. Andere Algorithmen um einen Stromsprung zu detektieren, können angewendet werden. Es ist z.B. möglich, fortlaufend den aktuellen Strommesswert mit dem von vor genau einer Netzperiode, z.B. 20ms bei 50 Hz, zu vergleichen. Tritt eine Abweichung auf, hat sich der Wechselstrom in Betrag und/oder Phase geändert.

Gemäß einer Ausführungsform der vorliegenden Erfindung liegt das Auswahlzeitintervall nicht außerhalb eines Begrenzungszeitintervalls vorbestimmter Dauer, das nach dem ersten Zeitpunkt liegt, und/oder wobei das Auswahlzeitintervall eine Zeitdauer von länger als 1 ms oder länger als 1,5 ms aufweist.

Die Stromänderung bzw. der zeitliche Verlauf des Abklingens des Stroms bei einem Drahtbruch im Sekundärkreis zu null hängt von der Zeitkonstante des Sekundärkreises, dem Verhältnis Widerstand zu Induktivität, ab. Die Werte dieser elektrischen Parameter variieren in verschiedenen Anwendungen und sind im allgemeinen nicht bekannt. Das Abklingen kann einige Millisekunden betragen. Ausführungsformen der vorliegenden Erfindung können herkömmlich verwendete Zeitfenster zum Prüfen des Stromes verlängern.

Mittels eines (absoluten oder fixen) Begrenzungszeitintervalls kann die Auswertung oder die Prüfung, ob der Strommittelwert kleiner ist als eine Stromwertschwelle zeitlich nach dem Sprung begrenzt werden, um nicht fehlerhaft einen Fehler im Sekundärstromkreis des Stromwandlers zu detektieren. Das Begrenzungszeitintervall kann zum Beispiel eine Dauer von zwischen 1 ms und 10 ms betragen. Wenn das Auswahlzeitintervall eine Zeitdauer zum Beispiel von länger als 1 ms oder auch länger als 1,5 ms aufweist, können zum Beispiel herkömmlich nicht-detektierte Fehler im Sekundärstromkreis des Stromwandlers detektiert werden.

Gemäß einer Ausführungsform der vorliegenden Erfindung umfasst das Auswahlzeitintervall mindestens ein erstes Zeitintervall, während dessen ein Betrag der Stromwertänderungsgröße größer als die Stromwertänderungsschwelle ist, wobei das erste Zeitintervall insbesondere bis zu einem zweiten Zeitpunkt reicht.

Die Stromwertänderungsgröße kann größer als die Stromwertänderungsschwelle vor, während oder nach dem detektierten Stromsprung sein. Während des ersten Zeitintervalls ist somit die Änderung des Stromes größer als unmittelbar davor und unmittelbar danach. Die Stromwertänderungsschwelle kann derart gewählt werden, dass bei erwartetem sinusförmigen Verlauf des Stroms, regulär (d.h. bei Fehlen eines Fehlers in dem Hochspannungsleiter) die Stromwertänderungsgröße immer kleiner ist als die Stromwertänderungsschwelle. Somit kann geschlossen werden, dass in dem ersten Zeitintervall ungewöhnliche Änderungen des Stroms auftreten bzw. aufgetreten sind, die nicht erwartet sind.

Das erste Zeitintervall kann von einem Zeitpunkt vor, bei oder nach dem ersten Zeitpunkt bis zu dem zweiten Zeitpunkt reichen, der nach dem ersten Zeitpunkt liegen kann. Wenn bestimmt ist, dass schon zu irgendeinem Zeitpunkt innerhalb des ersten Zeitintervalls der Strommittelwert kleiner ist als die Stromwertschwelle, so kann auf Vorliegen eines Fehlers im Sekundärstromkreis geschlossen werden.

Gemäß einer Ausführungsform der vorliegenden Erfindung umfasst das Auswahlzeitintervall mindestens ein zweites Zeitintervall, das nach dem ersten Zeitintervall liegt und insbesondere eine vorbestimmte Zeitdauer, insbesondere zwischen 0,5 ms und 2 ms, aufweist, wobei insbesondere während des zweiten Zeitintervalls der Betrag der Stromwertänderungsgröße gleich ist wie oder kleiner ist als die Stromwertänderungsschwelle.

Wenn bestimmt ist, dass der Strommittelwert bezogen auf einen Zeitpunkt innerhalb des zweiten Zeitintervalls kleiner ist als die Stromwertschwelle, so kann ebenfalls auf einen Fehler im Sekundärstromkreis des Stromwandlers geschlossen werden. Das zweite Zeitintervall erweitert somit das Kriterium zum Schließen auf einen Fehler im Sekundärstromkreis. Die Zeitdauer des zweiten Zeitintervalls kann zum Beispiel aus Trainingsdaten bestimmt sein und kann auch in Abhängigkeit der verwendeten Stromwertänderungsschwelle gesetzt werden. Zum Beispiel kann die vorbestimmte Zeitdauer des zweiten Zeitintervalls um so kleiner gewählt werden, je kleiner die Stromwertänderungsschwelle gewählt ist. Damit kann das Verfahren den individuellen Gegebenheiten der Anwendung angepasst werden.

Gemäß einer Ausführungsform der vorliegenden Erfindung lässt das Verfahren ferner auf Nichtvorhandensein eines Fehlers im Sekundärstromkreis schließen, falls ein Strommittelwert bezogen auf jeden Zeitpunkt, der in dem Auswahlzeitintervall liegt, größer ist als die Stromwertschwelle.

Das Auswahlzeitintervall kann dabei zum Beispiel mindestens das erste Zeitintervall umfassen oder kann zum Beispiel das erste Zeitintervall und zusätzlich das zweite Zeitintervall umfassen. Wenn auf Nichtvorhandensein eines Fehlers im Sekundärstromkreis geschlossen wurde, können die von dem Stromwandler ausgegebenen Stromwerte als von den Strömen im Hochspannungsleiter hervorgerufen angesehen werden.

Gemäß einer Ausführungsform der vorliegenden Erfindung ist die Stromwertänderungsgröße proportional zu einem Differenzenquotienten zweier Stromwerte oder Strommittelwerte und zweier zugeordneter Zeitpunkte bestimmt, wobei insbesondere ein Proportionalfaktor basierend auf einer Abtastfrequenz und einer Netzfrequenz bestimmt ist.

Damit kann die Stromwertänderungsgröße in einfacher Weise aus Stromwerten bzw. Strommittelwerten berechnet werden. Der Proportionalfaktor kann zum Beispiel ein Skalierungsfaktor sein bzw. der Proportionalfaktor kann zur Skalierung verwendet werden. Die Skalierung ist weiter unten mit scale_D beschrieben.

Die Stromwertänderungsschwelle und/oder die Stromwertschwelle müssen somit zeitlich nicht konstant sein, sondern können sich über der Zeit ändern. Damit kann eine geeignete Skalierung der Stromwertänderungsschwelle und/oder der Stromwertschwelle auf die tatsächlichen elektrischen Verhältnisse, das heißt tatsächlichen Ströme, bewirkt werden.

Gemäß einer Ausführungsform der vorliegenden Erfindung ist die Stromwertänderungsschwelle und/oder die Stromwertschwelle, insbesondere zeitlich dynamisch, basierend auf mindestens einem zeitlich zugeordneten tatsächlichen oder nominalen Stromwert und/oder Strommittelwert und/oder RMS-Stromwert oder Stromwertamplitude oder Effektivstromwert bestimmt, wobei die Stromwertänderungsschwelle größer als Null und insbesondere proportional zu einem RMS-Stromwert bestimmt ist.

Gemäß einer Ausführungsform der vorliegenden Erfindung ist die Stromwertschwelle insbesondere proportional zu einem nominalen Effektivstromwert bestimmt, wobei ein Proportionalfaktor insbesondere zwischen 3% und 10%, insbesondere 6% beträgt.

Gemäß einer Ausführungsform der vorliegenden Erfindung werden die Stromwerte durch wiederholte Abtastung, insbesondere mit Abtastfrequenz von mindestens 1 kHz erhalten, und/oder wobei der Strommittelwert durch Mittelung mindestens zweier, insbesondere zwischen zwei und zehn Stromwerten berechnet wird.

Der Primärstrom kann zum Beispiel einen sinusförmigen Strom umfassen, mit einer Netzfrequenz von zum Beispiel 50 Hz oder 60 Hz. Die Abtastrate kann um ein Vielfaches höher sein als die Netzfrequenz. Damit kann eine genaue Ermittlung der Stromwerte erreicht werden.

Gemäß einer Ausführungsform der vorliegenden Erfindung ist der Stromwandler sekundärseitig mit einem Schutzgerät verbunden, das insbesondere ausgebildet ist: mindestens einen Leistungsschalter im Hochspannungsleiter zu steuern, und/oder mindestens eine den Hochspannungsleiter betreffende Schutz- und/oder Überwachungsfunktion, insbesondere Unterstromfunktion, auszuführen. Damit kann das Verfahren für Überwachungs- und/oder Schutzfunktionen eingesetzt werden.

Gemäß einer Ausführungsform der vorliegenden Erfindung dienen die Stromwerte des Sekundärstromkreises des Stromwandlers als Messwerte zur Ermittlung eines Primärstroms, der in dem Hochspannungsleiter fließt, wobei Stromwerte des Primärstroms z.B. zwischen 40 A und 50000 A betragen, und/oder wobei Stromwerte im Sekundärkreis z.B. zwischen 0,5 A und 10 A betragen. Andere Werte sind möglich. Somit ist ein Einsatz für Überwachungs- und/oder Schutzfunktionen ermöglicht.

Gemäß einer Ausführungsform der vorliegenden Erfindung ist ein Verfahren eines Überwachens und/oder Durchführens einer Schutzfunktion eines Hochspannungsleiters, in dem ein Primärstrom fließt, bereitgestellt. Das Verfahren weist auf: Verwenden eines Stromwandlers, dessen Primärleiter durch einen Teil des Hochspannungsleiters gebildet ist; Detektieren eines vom Stromwandler angezeigten Unterstromzustandes; Durchführen eines Verfahrens eines Detektierens eines Fehlers, insbesondere Unterbrechung, in einem Sekundärstromkreis des Stromwandlers gemäß einer der vorangehenden Ausführungsformen; Falls auf einen Fehler im Sekundärstromkreis geschlossen wird: Unterlassen eines Durchführens einer Schutzfunktion, die für einen Fehlerzustand des Hochspannungsleiters vorgesehen ist.

Damit kann bei einem vom Stromwandler angezeigten Unterstromzustandes differenziert werden, ob dieser Fehlerzustand aufgrund eines Fehlers in dem Stromwandler zustande gekommen ist oder nicht. Falls auf einen Fehler im Sekundärstromkreis des Stromwandlers geschlossen wird, kann zum Beispiel vermieden werden, dass ein Leistungsschalter im Hochspannungskabel geöffnet wird, was einen Weiterbetrieb des Versorgungsnetzes behindern könnte.

Gemäß einer Ausführungsform der vorliegenden Erfindung weist das Verfahren ferner auf, falls auf Nichtvorhandensein eines Fehlers im Sekundärstromkreis geschlossen wird: Durchführens einer Schutzfunktion, die für einen Fehlerzustand des Hochspannungsleiters vorgesehen ist.

In diesem Fall kann geschlossen werden, dass der Stromwandler fehlerfrei arbeitet, so dass der angezeigte Unterstromzustand aufgrund des Zustandes des Hochspannungsleiters hervorgerufen wird. Wenn die Schutzfunktion daher durchgeführt wird, können Komponenten des Versorgungsnetzes vor Schäden geschützt werden.

Es sollte verstanden werden, dass Merkmale, die individuell oder in irgendeiner Kombination im Zusammenhang mit einem Verfahren eines Detektierens eines Fehlers in einem Sekundärstromkreis eines Stromwandlers erläutert, bereitgestellt, eingesetzt oder beschrieben worden sind, ebenfalls, individuell oder in irgendeiner Kombination, auf eine Vorrichtung zum Detektieren eines Fehlers in einem Sekundärstromkreis eines Stromwandlers angewendet, bereitgestellt oder eingesetzt werden können, gemäß Ausführungsformen der vorliegenden Erfindung und umgekehrt.

Gemäß einer Ausführungsform der vorliegenden Erfindung ist eine Vorrichtung zum Detektieren eines Fehlers, insbesondere Unterbrechung, in einem Sekundärstromkreis eines Stromwandlers, dessen Primärleiter durch einen Teil eines Hochspannungsleiters gebildet ist, bereitgestellt, wobei die Vorrichtung aufweist: einen Signaleingang, der ausgebildet ist, Stromwerte eines in dem Sekundärstromkreis fließenden elektrischen Stromes zu erhalten; einen Prozessor, der ausgebildet ist, eine Stromwertänderungsgrö-$\beta$e basierend auf mindestens zwei, verschiedenen Zeitpunkten zugeordneten, Stromwerten zu bilden; ein Logikmodul, das ausgebildet ist, auf einen Fehler im Sekundärstromkreis zu schließen, falls ein Betrag eines Strommittelwertes bezogen auf einen Zeitpunkt, der in einem Auswahlzeitintervall liegt, kleiner ist als eine Stromwertschwelle, wobei das Auswahlzeitintervall basierend auf einer Stromwertänderungsgröße und einer Stromwertänderungsschwelle bestimmt ist.

Die Vorrichtung kann mit Software und/oder Hardware implementiert sein, zum Beispiel ein Teil oder ein Modul eines Schutzgerätes repräsentieren.

Gemäß einer Ausführungsform der vorliegenden Erfindung ist ein System zum Überwachen und/oder Durchführen einer Schutzfunktion eines Hochspannungsleiters, in dem ein Primärstrom fließt, bereitgestellt, wobei das System aufweist: einen Stromwandlers, dessen Primärleiter durch einen Teil des Hochspannungsleiters gebildet ist; eine Vorrichtung gemäß einer der vorangehenden Ausführungsformen, dessen Signaleingang mit dem Stromwandler verbunden ist, einen Signalausgang zum Ansteuern zumindest einer Schutzfunktion; wobei das System ausgebildet ist, bei einem vom Stromwandler angezeigten Unterstromzustand; und beim vom Logikmodul angezeigten Fehler im Sekundärstromkreis, ein Ansteuern der Schutzfunktion, die für einen Fehlerzustand des Hochspannungsleiters vorgesehen ist, zu unterlassen.

Das System kann zum Beispiel ferner einen Teil des Hochspannungsleiters umfassen und/oder ein oder mehrere weitere Schutzgeräte, die zum Beispiel mit dem Stromwandler verbunden sind und die ein oder mehrere Leistungsschalter in dem Hochspannungsleiter zu steuern verbunden sind. Der Hochspannungsleiter kann zum Beispiel eine Ader eines mehrphasigen Hochspannungskabels eines Energieversorgungsnetzes bilden oder repräsentieren. Das System kann ausgebildet sein, ein oben erwähntes Verfahren eines Überwachens und/oder Durchführens einer Schutzfunktion durchzuführen oder zu steuern.

Ausführungsformen der vorliegenden Erfindung werden nun mit Bezug auf die beiliegenden Zeichnungen erläutert. Die Erfindung ist nicht auf die illustrierten oder beschriebenen Ausführungsformen beschränkt.

KURZE BESCHREIBUNG DER ZEICHNUNGEN

Fig. 1 illustriert in schematischer Ansicht ein System zum Überwachen und/oder Durchführen einer Schutzfunktion eines Hochspannungsleiters gemäß einer Ausführungsform der vorliegenden Erfindung, umfassend eine Vorrichtung zum Detektieren eines Fehlers in einem Stromwandler gemäß einer Ausführungsform der vorliegenden Erfindung;

Fig. 2 illustriert gemäß Ausführungsformen der vorliegenden Erfindung berechnete Stromgrößen;

Fig. 3 illustriert gemäß Ausführungsformen der vorliegenden Erfindung betrachtete Stromgrößen zur Detektion eines Fehlers in einem Stromwandler.

DETAILLIERTE BESCHREIBUNG VON AUSFÜHRUNGSFORMEN

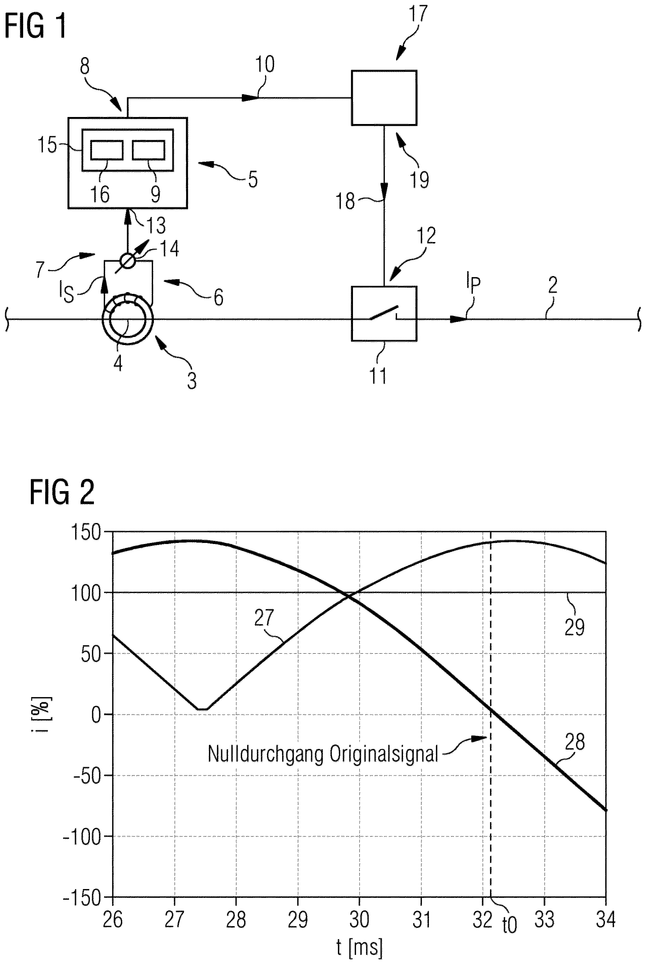

Das in **Fig. 1** schematisch illustrierte System 1 zum Überwachen und/oder Durchführen einer Schutzfunktion eines Hochspannungsleiters 2, in dem ein Primärstrom I_P fließt, weist einen Stromwandler 3 auf, dessen Primärleiter 4 durch einen Teil des Hochspannungsleiters 2 gebildet ist.

Das System 1 weist ferner eine Vorrichtung 5 zum Detektieren eines Fehlers in einem Sekundärstromkreis 6 des Stromwandlers 3 auf, wobei ein Signaleingang 7 der Vorrichtung 5 mit dem Stromwandler, insbesondere mit dessen Sekundärkreis 6, verbunden ist. Das System, insbesondere die Vorrichtung 5, weist ferner einen Signalausgang 8 auf, zum Ansteuern eines Leistungsschalters. Das System ist ausgebildet, bei einem vom Stromwandler 3 angezeigten Unterstromzustand und beim von einem Logikmodul 9 angezeigten Fehler im Sekundärkreis, ein Ansteuern der Schutzfunktion 17, wie für einen Unterstromzustand des Hochspannungsleiters 2 vorgesehen ist, zu unterlassen.

In der illustrierten Ausführungsform umfasst das System 1 ferner einen Leistungsschalter 11, der zur gesteuerten Unterbrechung des Hochspannungsleiters 2 vorgesehen und angeordnet ist. Der Hochleistungsschalter kann über einen Steuereingang 12 gesteuert werden. In der illustrierten Ausführungsform wird der Leistungsschalter 11 durch das Steuersignal 18, welches am Steuerausgang 19 der Schutzfunktion 17 ausgegeben wird, gesteuert. Falls der Stromwandler 3 fehlerfrei arbeitet, kann bei angezeigtem Fehlerzustand der Leistungsschalter 11 mittels des Steuersignals 18 geöffnet werden, um somit zum Beispiel einen Strom zu unterbrechen.

In anderen Ausführungsformen können ein oder mehrere andere Schutzgeräte bzw. Aktuatoren mittels eines Steuersignals 18 (und/oder durch Steuersignal 10) gesteuert werden, um zum Beispiel individuell auf einen detektierten Fehler im Hochspannungsleiter 2 ein oder mehrere Schutzfunktionen durchzuführen.

Die Vorrichtung 5 zum Detektieren eines Fehlers in dem Sekundärstromkreis 6 des Stromwandlers 3 weist den Signaleingang 7 auf, der ausgebildet ist, Stromwerte 13 eines in dem Sekundärstromkreis 6 des Stromwandlers 3 fließenden elektrischen Stromes I_S zu erhalten. In der illustrierten Ausführungsform ist in dem Sekundärstromkreis 6 ein Strommessgerät 14 angeordnet, um den Strom I_S zu messen und die entsprechenden Messwerte als Messsignale 13 auszugeben und der Vorrichtung 5 zuzuführen.

In der illustrierten Ausführungsform umfasst die Vorrichtung eine arithmetisch/logische Einheit 15, die ausgebildet ist, arithmetische und/oder logische Funktionen auszuführen. Insbesondere umfasst die Einheit 15 einen Prozessor 16, der ausgebildet ist, eine Stromwertänderungsgröße basierend auf mindestens zwei, verschiedenen Zeitpunkten zugeordneten, Stromwerten (z.B. repräsentiert durch Messwerte 13) zu bilden. Die Vorrichtung 5 umfasst ferner ein Logikmodul 9, das ausgebildet ist, auf einen Fehler im Sekundärstromkreis 6 des Stromwandlers 3 zu schließen, falls ein Strommittelwert bezogen auf einen Zeitpunkt, der in einem Auswahlzeitintervall liegt, kleiner ist als eine Stromwertschwelle. Das Auswahlzeitintervall ist dabei basierend auf einer Stromwertänderungsgrö-βe und einer Stromwertänderungsschwelle wie unten im Detail beschrieben wird, bestimmt.

Zum Beispiel kann mittels des Strommessgeräts 14 das Stromsignal I_S in dem Sekundärstromkreis 6 des Stromwandlers mit einer Abtastfrequenz von zum Beispiel 8 kHz (andere Werte sind möglich) abgetastet werden. Ausführungsformen der vorliegenden Erfindung können auf einen Drahtbruch im Sekundärstromkreis 6 des Stromwandlers 3 schließen, falls die Amplitude der Stromabtastwerte innerhalb eines Auswahlzeitintervalls nach einem Stromsprung monoton unter einen Schwellwert, zum Beispiel unter 6% des Nennstromes, fällt. Der Mittelwert I_MEAN der Amplituden der Stromwerte kann zum Beispiel über vier Abtastwerte nach folgender Formel bestimmt werden:

$$I_{MEAN}(n) = 0.25 \sum_{k=1}^{4} i\,(n - 4 + k)$$

$$(1)$$

wobei n der Abtastzeitpunkt im Signal und i die Amplitude eines Abtastwertes bezeichnet. Ein Strommittelwert kann gemäß Ausführungsformen der vorliegenden Erfindung auf andere Weise bestimmt werden, zum Beispiel über mehr oder weniger Abtastwerte gemittelt werden oder kann zum Beispiel auch als ein RMS-Wert über ein oder zwei oder mehrere Abtastwerte gemittelt bestimmt werden.

Gemäß einer Ausführungsform der vorliegenden Erfindung wird ein Drahtbruch im Sekundärkreis 6 des Stromwandlers 3 durch Betrachtung einer Stromwertänderungsgröße in Zusammenhang mit einem Strommittelwert erkannt. Dabei ist ein Drahtbruch im Sekundärkreis charakterisiert durch einen höheren Gradienten des abfallenden Stroms im Vergleich zu dem Gradienten eines sinusförmigen Stromverlaufs.

**Fig.** 2 illustriert in einem Koordinatensystem, wobei die Abszisse die Zeit und die Ordinate den Anteil an einer Nennamplitude anzeigt, Stromwert-betreffende Kurven eines sinusförmigen Stroms ohne Fehler im Sekundärkreis, welche gemäß Ausführungsformen der vorliegenden Erfindung betrachtet werden. Die Kurve 27 illustriert dabei den Betrag des Differenzenquotienten eines sinusförmigen Stroms (Kurve 28) mit einem Effektivwert von 100%. Bei einem Nulldurchgang der Stromwerte (Kurve 28), d.h. bei einem Zeitpunkt t0, hat der Differenzenquotient (Kurve 27) das Maximum von $\sqrt{2}$ des Effektivwertes des sinusförmigen Signals. Der Bereich um den Nulldurchgang des erwarteten Signals für einen normalen erwarteten Sinusverlauf (Kurve 18) weist erheblich geringere Gradienten auf als bei einem starken Abfall der Stromwerte, wie bei einem Drahtbruch. Die Kurve 29 repräsentiert den RMS-Wert der Stromwerte, welcher bei einem erwarteten sinusförmigen Verlauf bei Nennamplitude konstant bei 100% liegt.

Aus Fig. 2 ist ersichtlich, dass der höchste Gradient (Kurve 27) eines erwarteten regulären sinusförmigen Strom (Kurve 28) im Nulldurchgang des Stroms auftritt. Der Wert dieses Gradienten bestimmt damit den minimalen Stromschwellenänderungsschwellwert zur Diskriminierung von einem Drahtbruch.

Gemäß einer Ausführungsform der vorliegenden Erfindung wird die erste Ableitung bzw. der Differenzenquotient als ein geeignetes Kriterium zur Drahtbrucherkennung verwendet. Gemäß einer Ausführungsform der vorliegenden Erfindung kann die Stromwertänderungsgröße (z.B. Differenzenquotient (I_MEAN_D)) nach folgender Formel berechnet werden:

$$I_{MEAN\_D}(n) = \frac{\Delta I_{MEAN}}{\Delta T_A}$$

Durch die Wahl eines Abtastzeitintervalls von 0,5 ms entspricht einer Abtastfrequenz von 2 kHz ergibt sich bezogen auf den 8 kHz-Datenstrom folgender Zusammenhang:

$$I_{MEAN\_D}(n) = \frac{\Delta I_{MEAN}}{\Delta T_A} = \left(I_{MEAN}(n) - I_{MEAN}(n - 4)\right) scale_d$$

$$(2)$$

wobei n den Abtastzeitpunkt im Signal bezeichnet. Wie aus der obigen Formel (2) hervorgeht, kann die Stromwertänderungsgröße proportional zu einem Differenzenquotienten zweier Stromwerte oder Strommittelwerte zweier zugeordneter Zeitpunkte bestimmt werden.

Die Skalierung scale_D des Differenzenquotienten zu der sinusförmigen Signalamplitude der Netzfrequenz f kann zum Beispiel mit folgendem Faktor realisiert werden:

$$scale_d = \frac{1}{\sqrt{2 + 2cos\frac{2\pi f}{f_A}}}$$

wobei f_A die Abtastfrequenz der Differenzenquotientbildung (im Beispiel 2 kHz) und f die aktuelle Signalfrequenz (Netzfrequenz) ist.

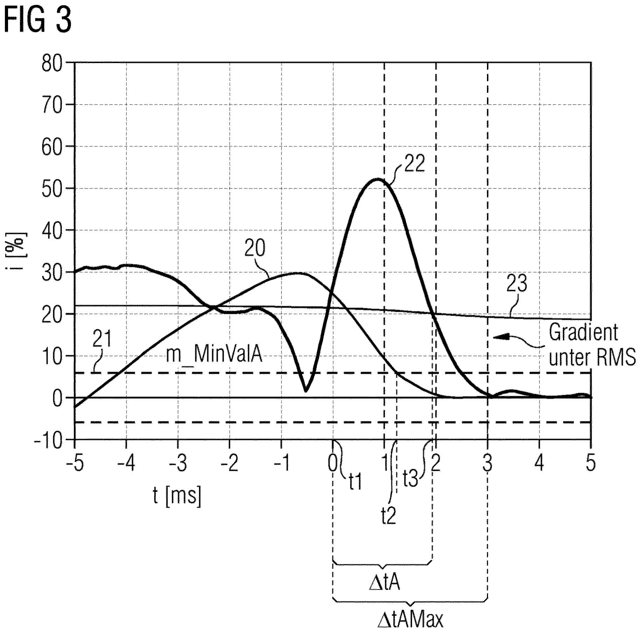

**Fig. 3** zeigt Kurven in einem Koordinatensystem mit Abszisse, welche die Zeit anzeigt und Ordinate, welche den Anteil einer Amplitude anzeigt. Die Kurve 20 illustriert den Verlauf des Strommittelwertes. Die Kurve 21 illustriert den Verlauf einer Stromwertschwelle, die Kurve 22 illustriert den Verlauf eines Betrages einer Stromwertänderungsgröße (hier wie in der Gleichung (2) oben berechnet) und die Kurve 23 illustriert den Verlauf einer Stromwertänderungsschwelle, wie gemäß Ausführungsformen der vorliegenden Erfindung bereitgestellt ist.

Bei einem ersten Zeitpunkt t1 wird ein Stromsprung detektiert, zum Beispiel falls mindestens ein Stromwert von einem erwarteten Stromwert mehr als um eine vorbestimmte Stromwertabweichung sich unterscheidet. Gemäß einer Ausführungsform der vorliegenden Erfindung wird ab diesem ersten Zeitpunkt t1 auch eine Stromwertänderungsgröße (z.B. Kurve 22) bestimmt, um sie mit der Stromwertänderungsschwelle (Kurve 23) zu vergleichen. Gemäß einer Ausführungsform der vorliegenden Erfindung wird innerhalb eines Auswahlzeitintervalls ΔtA bestimmt, ob es einen Zeitpunkt innerhalb dieses Auswahlzeitintervalls ΔtA gibt, in dem der Betrag des Strommittelwertes 20 kleiner ist als die Stromwertschwelle 21. In dem vorliegenden Beispiel ist ab dem Zeitpunkt t2 innerhalb des Auswahlzeitintervalls ΔtA der Strommittelwert 20 kleiner als die Stromwertschwelle 21 und es wird auf einen Fehler im Sekundärstromkreis 6 des Stromwandlers 3 geschlossen.

Das Auswahlzeitintervall ΔtA umfasst das Zeitintervall, währenddessen ein Betrag 22 der Stromwertänderungsgröße größer ist als die Stromwertänderungsschwelle 23.

Damit reicht das Auswahlzeitintervall ΔtA genau bis zu einem dritten Zeitpunkt t3, bei dem der Betrag 22 der Stromwertänderungsgröße die Stromwertänderungsschwelle 23 von oben nach unten kreuzt.

Gemäß einer anderen Ausführungsform kann die maximale Länge des Auswahlzeitintervalls ΔtA eine vorbestimmte Dauer ΔtAMax haben. Wenn innerhalb des gesamten Auswertezeitintervalls ΔtAMax der Strommittelwert 20 (immer) größer ist als die Stromwertschwelle 21, kann auf Nichtvorhandensein eines Fehlers im Sekundärstromkreis 6 des Stromwandlers geschlossen werden. Z.B. kann das Intervall ΔtAMax bis zu einem Zeitpunkt reichen, der um z.B. 1 ms oder länger als 1 ms nach dem dritten Zeitpunkt t3 liegt. Z.B. kann das Intervall ΔtAMax bei dem ersten Zeitpunkt t1 beginnen und eine Dauer von zwischen 1 ms und 3 ms haben.

Wie aus Fig. 3 ersichtlich ist, kann sowohl die Stromwertänderungsschwelle 23 als auch die Stromwertschwelle 21 dynamisch in Abhängigkeit der Zeit basierend auf einem tatsächlichen oder nominalen Stromwert und/oder Strommittelwert oder RMS-Stromwert oder Stromwertamplitude oder Effektivstromwert bestimmt sein. Insbesondere ist die Stromwertänderungsschwelle 23 nicht über die Zeit konstant, sondern verändert sich mit der Zeit.

Wie aus Fig. 1 ersichtlich, ist der Stromwandler 3 sekundärseitig mit der Vorrichtung 5 verbunden, die auch als ein Schutzgerät ausgebildet sein kann und dazu über den Steuereingang 7 und den Steuerausgang 8 verfügt wie oben näher beschrieben ist.

Die Stromwerte 13 des Sekundärstromkreises 6 dienen zur Ermittlung des Primärstroms I_P, welcher in dem Hochspannungsleiter 3 fließt.

Die Vorrichtung 5 bzw. das System 1, welche in Fig. 1 illustriert sind, können ausgebildet sein, ein Verfahren eines Detektierens eines Fehlers in dem Sekundärstromkreis 6 des Stromwandlers 3 durchzuführen bzw. ein Verfahren eines Überwachens bzw. Durchführens einer Schutzfunktion eines Hochspannungsleiters durchzuführen oder zu steuern.

Die Fig. 3 illustriert dabei den betragsmäßigen Signalverlauf 22 des Differenzenquotienten I_MEAN_D für den realen Drahtbruch im Sekundärstromkreis des Stromwandlers. Der Betrag des Differenzenquotienten (Kurve 22) ist eine Millisekunde nach dem Sprung (bei dem ersten Zeitpunkt t1) höher als die Stromwertänderungsschwelle 23, das heißt im hier illustrierten Fall größer als der Schwellwert F_D x I_RMS, obwohl sich nach einer Millisekunde der Mittelwert (Kurve 20) nicht unter dem Strommindestschwellwert (Kurve 21) befindet. Zwei Millisekunden nach dem Sprung ist der Differenzenquotient (Kurve 22) kleiner als der Schwellwert (Kurve 23) und das Mindestkriterium wird erfüllt. Das heißt, durch eine verzögerte Auswertung gemäß einer Ausführungsform der vorliegenden Erfindung kann ein Drahtbruch sicher erkannt werden.

Der maximale Differenzenquotient eines sinusförmigen Signals tritt im Nulldurchgang auf und beträgt genau $\sqrt{2}$ des RMS-Wertes. Der Faktor F_D kann so gewählt werden, dass zwischen Drahtbruch und sinusförmigen Stromverlauf unterschieden werden kann, wobei bei einem Drahtbruch höhere Gradienten auftreten. Wenn der Faktor größer als $\sqrt{2}$, zum Beispiel 2, gewählt wird, kann eine fälschliche Drahtbrucherkennung bei einem sinusförmigen Signal vermieden werden (. Gleichzeitig kann aber auch bei einem Drahtbruch in der Nähe des Nulldurchganges ein gesicherter Drahtbruch erkannt werden, da die Prüfung des Mindeststromkriteriums nur verzögert wird und keine sofortige Abweisung erfolgt.

Das Kriterium des Differenzenquotienten kann im Falle eines vermuteten Drahtbruchs, das heißt nachdem ein Stromsprung erkannt worden ist (Zustand "fallend") derart angewendet werden, dass der Zustand "fallend" so lange beibehalten wird, so lange die Beträge des Differenzenquotienten einen Schwellwert überschreiten. So wird der RMS-Wert des abgetasteten Signals mit einem Faktor F_D, zum Beispiel 2, multipliziert. Zusätzlich kann man eine maximale Anzahl von Messwiederholungen m definieren, zu denen die Kriterien Differenzenquotienten und Minimum geprüft werden.

Tabelle 1:

| $I_{MEAN\,D} > F_D$ TrueRMS | $I_{MEAN\,D} \leq F_D$ TrueRMS | |
|---|---|---|
| Beibehaltung des Zustand *"FALLEND",* Nach m Messwiederholungen -> "ABWEISUNG" | $I_{MEAN} <$ minVal | $I_{MEAN} >$ minVal |
| | $\rightarrow$ "DRAHTBRUCH" | $\rightarrow$ "ABWEISUNG" |

Falls die Differenzenquotienten den Schwellwert F_D x I_RMS unterschreiten, wird sofort geprüft, ob der Mittelwert I_MEAN der Abtastwerte den Schwellwert Minimum unterschreitet. In diesem Fall ist von einem gesicherten Drahtbruch auszugehen, andererseits von keinem Drahtbruch (siehe Tabelle 1).

Gemäß Ausführungsformen der vorliegenden Erfindung ermöglicht das Zusatzkriterium der Differenzenquotienten eine sichere Drahtbrucherkennung in einem Sekundärstromkreis eines Stromwandlers. Außerdem wird die fälschliche Erkennung eines Drahtbruchs vermieden. Damit führt die Einführung des Zusatzkriteriums zu einer deutlichen Verbesserung der Drahtbrucherkennung. Damit kann besser zwischen normalen Vorgängen im Netz und Fehler im Sekundärkreis des Stromwandlers unterschieden werden. Insbesondere die Auslösesicherheit und die Stabilität von Differentialschutzfunktionen kann damit verbessert werden.

**Patentansprüche**

1. Verfahren eines Detektierens eines Fehlers, insbesondere Unterbrechung, in einem Sekundärstromkreis (6) eines Stromwandlers (3), dessen Primärleiter (4) durch einen Teil eines Hochspannungsleiters (2) gebildet ist, wobei das Verfahren aufweist:

   Schließen auf einen Fehler im Sekundärstromkreis (6), falls ein Betrag des Strommittelwertes (20) bezogen auf einen Zeitpunkt, der in einem Auswahlzeitintervall (ΔtA) liegt, kleiner ist als eine Stromwertschwelle (21),
   wobei das Auswahlzeitintervall (ΔtA) basierend auf einer Stromwertänderungsgrö-βe (22) und einer Stromwertänderungsschwelle (23) bestimmt ist,
   wobei die Stromwertänderungsgröße (22) basierend auf mindestens zwei, verschiedenen Zeitpunkten zugeordneten, Stromwerten (13) eines in dem Sekundärstromkreis (6) fließenden elektrischen Stromes (I_P) gebildet ist.

2. Verfahren gemäß dem vorangehenden Anspruch,
   wobei das Auswahlzeitintervall (ΔtA) umfassend einen und/oder nach einem ersten Zeitpunkt (t1) liegt, bei dem ein Stromsprung detektiert wurde, insbesondere bei dem sich mindestens ein Stromwert (13) von einem erwarteten Stromwert (18), insbesondere eines sinusförmigen Verlaufes, um mehr als eine vorbestimmte Stromwertabweichung unterscheidet.

3. Verfahren gemäß einem der vorangehenden Ansprüche,

   wobei das Auswahlzeitintervall (ΔtA) nicht außerhalb eines maximalen Begrenzungszeitintervalls (ΔtAMax) vorbestimmter Dauer liegt, das nach dem ersten Zeitpunkt liegt, und/oder
   wobei das Auswahlzeitintervall eine Zeitdauer von mindestens 1 ms aufweist.

4. Verfahren gemäß einem der vorangehenden Ansprüche,

   wobei das Auswahlzeitintervall (ΔtA) ein Zeitintervall umfasst, während dessen ein Betrag der Stromwertänderungsgröße (22) größer als die Stromwertänderungsschwelle (23) ist,
   wobei das Auswahlzeitintervall (ΔtA) insbesondere bis zu einem dritten Zeitpunkt (t3) reicht.

**5.** Verfahren gemäß einem der vorangehenden Ansprüche, ferner aufweisend:

Schließen auf Nichtvorhandensein eines Fehlers im Sekundärstromkreis, falls ein Strommittelwert (20) bezogen auf jeden Zeitpunkt, der in dem Auswahlzeitintervall (ΔtA) liegt, größer ist als die Stromwertschwelle (21).

**6.** Verfahren gemäß einem der vorangehenden Ansprüche,
wobei die Stromwertänderungsgröße (22) proportional zu einem Differenzenquotienten zweier Stromwerte oder Strommittelwerte (I_mean) und zweier zugeordneter Zeitpunkte bestimmt ist,
wobei insbesondere ein Proportionalfaktor (scale_d) basierend auf einer Abtastfrequenz (f_A) und einer Stromfrequenz (f) bestimmt ist.

**7.** Verfahren gemäß einem der vorangehenden Ansprüche,

wobei die Stromwertänderungsschwelle (23) und/oder die Stromwertschwelle (21), insbesondere zeitlich dynamisch, basierend auf mindestens einem zeitlich zugeordneten tatsächlichen oder nominalen Stromwert und/oder Strommittelwert und/oder RMS-Stromwert oder Stromwertamplitude oder Effektivstromwert bestimmt ist,
wobei die Stromwertänderungsschwelle (22) größer als Null und insbesondere proportional zu einem RMS-Stromwert bestimmt ist, wobei ein Proportionalfaktor (F_D) größer als √2 beträgt.

**8.** Verfahren gemäß einem der vorangehenden Ansprüche,
wobei die Stromwertschwelle (21) insbesondere proportional zu einem nominalen Effektivstromwert bestimmt ist,
wobei ein Proportionalfaktor insbesondere zwischen 3% und 10%, insbesondere 6% beträgt.

**9.** Verfahren gemäß einem der vorangehenden Ansprüche,

wobei die Stromwerte (13) durch wiederholte Abtastung, insbesondere mit Abtastfrequenz von mindestens 1 kHz erhalten werden, und/oder
wobei der Strommittelwert (I_mean) durch Mittelung mindestens zweier, insbesondere zwischen zwei und zehn, Stromwerte berechnet wird.

**10.** Verfahren gemäß einem der vorangehenden Ansprüche,
wobei der Stromwandler (3) sekundärseitig mit einem Schutzgerät (5) verbunden ist,
das insbesondere ausgebildet ist:

mindestens einen Leistungsschalter (11) im Hochspannungsleiter (2) zu steuern, und/oder
mindestens eine den Hochspannungsleiter (2) betreffende Schutz- und/oder Überwachungsfunktion, auszuführ-ren.

**11.** Verfahren gemäß einem der vorangehenden Ansprüche,
wobei die Stromwerte (13) des Sekundärstromkreises des Stromwandlers (3) als Messwerte zur Ermittlung eines Primärstroms (I_P), der in dem Hochspannungsleiter (2) fließt, dienen.

**12.** Verfahren eines Überwachens und/oder Durchführens einer Schutzfunktion eines Hochspannungsleiters (2), in dem ein Primärstrom (I_P) fließt, wobei das Verfahren aufweist:

Verwenden eines Stromwandlers (3), dessen Primärleiter (4) durch einen Teil des Hochspannungsleiters (2) gebildet ist;
Detektieren eines vom Stromwandler (3) angezeigten Unterstromzustandes;
Durchführen eines Verfahrens eines Detektierens eines Fehlers, insbesondere Unterbrechung, in einem Sekundärstromkreis (6) des Stromwandlers (3) gemäß einem der vorangehenden Ansprüche;
Falls auf einen Fehler im Sekundärstromkreis geschlossen wird:
Unterlassen eines Durchführens einer Schutzfunktion, die für einen Fehlerzustand des Hochspannungsleiters (2) vorgesehen ist.

**13.** Verfahren gemäß dem vorangehenden Anspruch, ferner aufweisend:
Falls auf Nichtvorhandensein eines Fehlers im Sekundärstromkreis (6) geschlossen wird:
Durchführens einer Schutzfunktion, die für einen Fehlerzustand des Hochspannungsleiters (2) vorgesehen ist.

**14.** Vorrichtung (5) zum Detektieren eines Fehlers, insbesondere Unterbrechung, in einem Sekundärstromkreis (6) eines Stromwandlers (3), dessen Primärleiter (4) durch einen Teil eines Hochspannungsleiters (2) gebildet ist, wobei die Vorrichtung aufweist:

einen Signaleingang (7), der ausgebildet ist, Stromwerte (13) eines in dem Sekundärstromkreis (6) fließenden elektrischen Stromes (I_S) zu erhalten;

einen Prozessor (16), der ausgebildet ist, eine Stromwertänderungsgröße (22) basierend auf mindestens zwei, verschiedenen Zeitpunkten zugeordneten, Stromwerten (13) zu bilden;

ein Logikmodul (9), das ausgebildet ist, auf einen Fehler im Sekundärstromkreis zu schließen, falls ein Betrag des Strommittelwertes (20) bezogen auf einen Zeitpunkt, der in einem Auswahlzeitintervall (ΔtA) liegt, kleiner ist als eine Stromwertschwelle (21),

wobei das Auswahlzeitintervall (ΔtA) basierend auf einer Stromwertänderungsgrö-βe (22) und einer Stromwertänderungsschwelle (23) bestimmt ist.

**15.** System (1) zum Überwachen und/oder Durchführen einer Schutzfunktion eines Hochspannungsleiters (2), in dem ein Primärstrom (I_P) fließt, wobei das System aufweist:

einen Stromwandler (3), dessen Primärleiter (4) durch einen Teil des Hochspannungsleiters (2) gebildet ist;

eine Vorrichtung (5) gemäß einem der vorangehenden Ansprüche, deren Signaleingang (7) mit dem Stromwandler (3) verbunden ist,

einen Signalausgang (8) zum Ansteuern zumindest einer Schutzfunktion (17); wobei das System ausgebildet ist, bei einem vom Stromwandler (3) angezeigten Unterstromzustand;

und beim vom Logikmodul (9) angezeigten Fehler im Sekundärstromkreis, ein Ansteuern (10) der Schutzfunktion (17), die für einen Fehlerzustand des Hochspannungsleiters (2) vorgesehen ist, zu unterlassen.

FIG 1

FIG 2

Nulldurchgang Originalsignal

t [ms]

# FIG 3

Europäisches
Patentamt

European
Patent Office

Office européen
des brevets

## EUROPÄISCHER RECHERCHENBERICHT

**Nummer der Anmeldung**

EP 24 19 5166

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2018/278041 A1 (ODA SHIGETOO [JP]) 27. September 2018 (2018-09-27) | 1,3-5, 8-15 | INV. H02H3/04 |
| A | * Absätze [0058] - [0068]; Abbildung 6 * ----- | 2,6,7 | G01R31/62 |
| A | CN 101 512 861 A (SIEMENS AG [DE]) 19. August 2009 (2009-08-19) * das ganze Dokument * ----- | 1-15 | ADD. H02H3/05 |
| A | CN 102 122 810 B (SHANGHAI NOARK ELECTRIC CO LTD) 6. November 2013 (2013-11-06) * das ganze Dokument * ----- | 1-15 | |

**RECHERCHIERTE SACHGEBIETE (IPC)**

H02H
G01R

Der vorliegende Recherchenbericht wurde für alle Patentansprüche erstellt

| Recherchenort | Abschlußdatum der Recherche | Prüfer |
|---|---|---|
| München | 5. Februar 2025 | Trifonov, Antoniy |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
....................................................................
& : Mitglied der gleichen Patentfamilie, übereinstimmendes
    Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 24 19 5166

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-02-2025

| Im Recherchenbericht angeführtes Patentdokument | Datum der Veröffentlichung | Mitglied(er) der Patentfamilie | Datum der Veröffentlichung |
|---|---|---|---|
| US 2018278041 A1 | 27-09-2018 | JP 5881919 B1 | 09-03-2016 |
| | | JP WO2016199293 A1 | 22-06-2017 |
| | | KR 20170140389 A | 20-12-2017 |
| | | US 2018278041 A1 | 27-09-2018 |
| | | WO 2016199293 A1 | 15-12-2016 |
| CN 101512861 A | 19-08-2009 | CN 101512861 A | 19-08-2009 |
| | | DE 112006004145 A5 | 10-09-2009 |
| | | EP 2064793 A1 | 03-06-2009 |
| | | WO 2008034400 A1 | 27-03-2008 |
| CN 102122810 B | 06-11-2013 | KEINE | |

EPO FORM P0461

Für nähere Einzelheiten zu diesem Anhang : siehe Amtsblatt des Europäischen Patentamts, Nr.12/82